# EUROPEAN PATENT SPECIFICATION

(11) **EP 0 888 630 B1**
(45) Date of publication and mention of the grant of the patent: **04.12.2002**
(21) Application number: 97914175.1
(22) Date of filing: 21.03.1997
(51) Int. Cl.: H01G 4/40

(54) **A METHOD OF PRODUCING AN LC-CIRCUIT**
VERFAHREN ZUR HERSTELLUNG EINER LC-SCHALTUNG
PROCEDE DE FABRICATION DE CIRCUIT LC

(30) Priority: 22.03.1996 DK 33596
(43) Date of publication of application: 07.01.1999
(73) Proprietor: THE WHITAKER CORPORATION, Wilmington, DE 19808 (US)
(72) Inventor: HOLM, Jens, Peter, DK-2970 Horsholm (DK)
(74) Representative: Siiger, Joergen
(86) International application number: DK9700124
(87) International publication number: WO97036306

(56) References cited:
- US-A- 5 197 170
- PATENT ABSTRACTS OF JAPAN, Vol. 95, No. 07; & JP,A,07 106 200 (MURATA MFG CO LTD), 21 April 1995.

## Description

### Technical Field.

The invention relates to a method of producing an LC-circuit in form of a single component, where the inductor and capacitor elements are arranged atop one another, and where the inductor elements are formed by ferro-magnetic zones composed of layers of ferrite of a high permeability, electrode layers being provided between said layers of ferrite, and where the capacitor elements are formed by dielectric zones made of dielectric paste with electrode layers on both sides, said inductor and capacitor elements being produced by means of tape or thick-film technology or combinations thereof.

### Background Art

It is known to employ sintering to define capacitive elements in a chip component which also includes subsequently defined non-ferromagnetic inductor elements. For example, in U.S. Patent No. 5, 197, 170 there is disclosed a method for producing an LC component by alternatively laminating a ceramic layer and a capacitor electrode layer on a substrate, and sintering the substrate to thereby form one or more capacitor elements thereon. The inductor element(s), however, are then formed not by sintering but by sputtering Ti, Ti-Ag, and AG over the entire surface of the substrate to form a conductive film having three layers. The sputtering step is followed by photoresist deposition and photoetching steps in order to form the inductor elements in the form of spiral coil patterns on the substrate.

The use of ferromagnetic materials for structuring chip components comprising both inductors and capacitors has previously been limited by the difficulty in using ferromagnetic materials in connection with dielectric materials. The inductors are often made of a ferrite and are used by way of known printing methods for structuring layer structures including internal conducting paths. These inductors have low inductances due to the low permeability of the ferromagnetic material. EP-PS No. 297 565 discloses for instance a ferromagnetic material of a relatively low permeability caused by a very small granular size and a high content of glass. Attempts have been made at obtaining a higher permeability by raising the sintering temperature or increasing the sintering period, but from a productional point of view such procedures are disadvantageous or necessitate the use of cost-intensive electrode materials, such as Pd. Thus the material described in EP-PS No. 297 565 requires a sintering period of 30 -220 min., which makes a production under usual thick-film conditions difficult. Furthermore, the final components have a relatively poor mechanical strength.

Moreover chip components comprising both inductors and capacitors suffer from delamination and distortion at the interface zone between the ferromagnetic and the dielectric zones. Chip components comprising both inductors and capacitors are furthermore encumbered with problems due to reactions at the interface between the ferromagnetic and the dielectric zones, whereby the characteristics of these materials are deteriorated.

These problems can be set right by the ferromagnetic zones being separated from the dielectric zones of the capacitors by means of a blocking layer, cf. Danish Patent Application No. 908/91 or insulating sheets, conf. US-A-5197-170.

### Brief Description of the Invention

Such an additional blocking layer should, however, be avoided, and a method of the above type is according to the invention characterised by initially providing the capacitor elements, which are sintered at a first temperature, followed by application of the inductor elements whereafter a sintering is performed at a second temperature which is sufficiently lower than said first sintering temperature to avoid undesired reactions between the ferromagnetic zones and the dielectric zones. In this manner undesired reactions are avoided between the two zones. Furthermore you have a free hand concerning the choice of dielectrics for the capacitor elements in such a manner that desired properties, such as high dielectric constants, i.e. high capacity values, in the same number of layers can be optimized.

According to a particularly advantageous embodiment, the capacitor elements are provided by means of dielectric having ε_{R}<250, such as a ceramic powder of the type TAM NPO CL 750, which is mixed with a binder and cast in thin layers, whereafter an electrode material is applied. In this manner the capacitor elements obtain particularly high dielectric constants, i.e. high capacity values.

### Brief Description of the Drawings

The invention is explained in greater detail below with reference to the accompanying drawing, in which
Fig. 1 is an exploded view of a multilayer -LC-circuit according to the invention,
Fig. 2 illustrates an equivalence diagram of the LC-circuit, and
Fig. 3 shows the final LC-circuit in form of a single component.

### Best Mode for Carrying Out the Invention

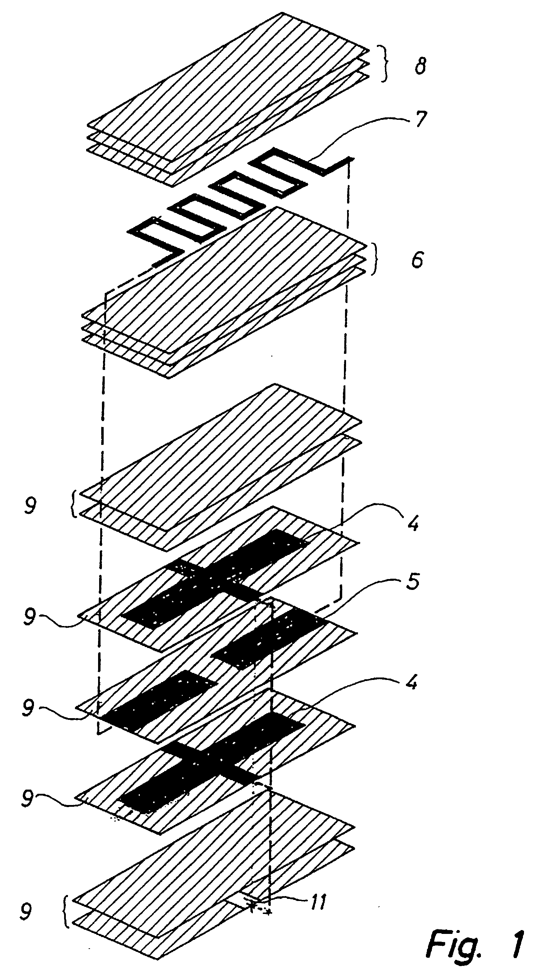

The multilayer LC-circuit of Fig. 1 comprises at least one ferromagnetic and at least one dielectric zone forming inductors and capacitors, respectively. Previously, it has been difficult to use ferromagnetic materials in connection with dielectric materials. According to the invention, the process conditions have been divided such that undesired reactions between the materials have been avoided.

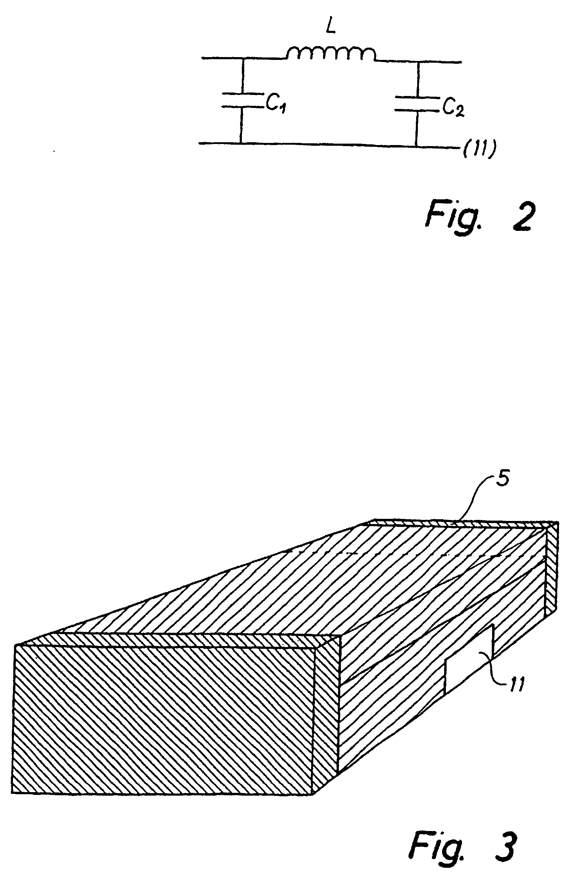

Below an example is described, where the principle is used for producing multilayer Pi- filters comprising two capacitors and one inductor, cf. Fig. 2. The two capacitors C₁, C₂ are produced by means of multilayer tape, whereas the inductor L is produced by way of serigraphy technology.

The process steps are as follows:
a) A ceramic powder for instance of the type TAM NPO is mixed with a PVB binder for instance of the type MSI B73221 in the ratio of 55 weight% of ceramic powder to 45 weight% of binder in a container with zirconium balls for about 16 hours. The mixture is then cast in thin layers of a thickness of about 35 - 40 µm on a carrier film, such as a mylar film. The ceramic layers are removed from the carrier film and adhered to frames, cf. the article "Production of ceramic multilayer chip-capacitors" by Ole Pedersen, Ferroperm in Elektronik 1, 1983), whereafter to the ceramic tape on the inner side is applied an electrode material, which is for instance Gwent C30111D1 (70% AG, 30% Pd). After air-drying of the applied electrode, the layers are individually punched in a matrix. Then the layers are laminated together into a block (at a pressure of about 20,7x10⁶ N/m² (3000 psi) and a temperature of about 70°C). Then the binder is slowly burnt off in the finished multilayer block. The block is then sintered in an oven at a temperature of about 1100°C for about 2 hours.
b) The used ferrite paste is for instance composed of Li_{0.5(1+t-z-c)}, Zn_{z}, Mnₘ, Tiₜ, Co_{c}, Fe_{(1-0.2z-0.6t-0.4m-0.2c-ε)}, where 0≤t≤0.2; 0.2≤x≤0.5; 0.2≤n≤0.4; 0.02≤c≤0.05, and ε are of the magnitude 0.06.
c) On the rear side of the ceramic substrate, electrodes 4 of Ag/Pd/Pt, such as DuPont, are serigraphed which is to serve as frame termination. The internal frame electrodes are connected later on to the frame termination by means of rim terminations. The frame termination are burnt on at about 750°C. Then the substrate is turned, and a plurality of ferrite layers 6 are serigraphed until the thickness is about 0. 25 mm. Internal silver electrodes and necessary cutting marks are serigraphed twice, whereafter a plurality of ferrite layers 8 are again serigraphed until the total thickness of the ferrite layers is about 0.5 mm. The entire structure is then sintered at a temperature which is below the melting point of silver, such as 910°C, for one to two hours.
d) The ceramic substrate with the applied and sintered ferrite material is adhered to a steel plate with a glass base by means of shellac. On a cutting machine with diamant blades, a cutting is initially carried out in one direction through cutting masks applied together with the silver electrodes. The plates are then turned 90°, and a cutting is performed in the opposite direction. The items cut out are washed in ethanol and subjected to a rim- end termination by means of Ag/Pd/Pt termination paste of the type DuPont 4933 D.

The ceramic material is typically barium titanate-based, such as
TAMTRON CL750 product No. 58221
TAMTRON COG150L product No. 52622
TAMTRON COG600L product No. 52601 i.e. materials sintering at temperatures above 1000°C. Other ceramic materials can be used.

As ferrite material is used LiMe₂O₄, such as
FERROPERM A/S: L34 (lithium spinel ferrite)
FERROPERM A/S: L48 i.e. materials sintering at temperatures below 960°C. Other ferrite materials can, however, also be used.

As conducting material in the capacitor elements is used Ag/Pd, such as
Gwent: C30111D1 70Ag/30Pd
ESL: 9637-B

As conducting material in the inductor elements is used Ag/Pd, such as

| | |
|---|---|
| DuPont: 6160 | (100% Ag) |
| ESL: 9912-f | (100% Ag) |
| ESL: 9990 | (100% Ag) |

Other conducting materials in the inductor elements can, however, also be used, such as gold. The conductor paths 7 can for instance be meander--shaped, cf. Fig. 1.

The inductor L is typically of 100 nH whereas the capacitors C₁, C₂ typically are of 2 x 1 nF. Fig 1 shows further the interconnections between the components.

During the production, a temperature difference must apply by the processes at the capacitor elements and the inductor elements, respectively, of at least 50°C. In this manner undesired reactions are avoided between the two zones. The temperature difference is typically 200°C.

## Claims

1. A method of producing an LC-circuit in form of a single component, in which the inductor and the capacitor elements are arranged atop one another, and where the inductor elements are formed by ferro-magnetic zones comprised of layers (6, 8) of ferrite of a high permeability, and between which electrode layers (7) are provided, and where the capacitor elements are formed by dielectric zones made of layers of dielectric with electrode layers on both sides, said inductor and capacitor elements being produced by way of tape or thick-film technology or combination thereof, **characterized by** initially providing the capacitor elements which are sintered at a first temperature followed by application of the inductor elements, whereafter a sintering is performed at a second temperature which is sufficiently lower than said first sintering temperature to avoid undesired reactions at interfaces between the ferro-magnetic zones and the dielectric zones.

2. A method as claimed in claim 1, **characterized by** the temperature difference between the first and second sintering temperatures being at least 50°C, and typically 200°C.

3. A method as claimed in claim 1, **characterised in that** the capacitor elements (9, 4, 5) are sintered at a temperature above 1000°C, such as 1100°C, whereas the entire structure after the application of the inductor elements (6, 7, 8) is sintered at a temperature below about 960°C, such as 910°C.

4. A method as claimed in one or more of the preceding claims, **characterised in that** the capacitor elements (9, 4, 5) are provided by means of dielectric of ε_{R}<250, such as a ceramic powder of the type TAM NPO CL750, which is mixed with a binder and cast in thin layers, whereafter electrode material (4, 5) is applied.

## Patentansprüche

1. Verfahren zur Herstellung einer LC-Schaltung in Form einer einzigen Komponente, in dem die induktiven und kapazitiven Elemente aufeinander angeordnet werden und die induktiven Elemente durch ferromagnetische Zonen gebildet werden, die aus Schichten (6, 8) aus Ferrit mit einer hohen Permeabilität bestehen, und zwischen denen Elektrodenschichten (7) vorgesehen werden, und in dem die kapazitiven Elemente durch dielektrische Zonen, die aus Dielektrikumschichten hergestellt sind, mit Elektrodenschichten auf beiden Seiten gebildet werden, wobei die induktiven und kapazitiven Elemente mittels Tape- oder Dickschicht-Technologie beziehungsweise einer Kombination derselben hergestellt werden,
**gekennzeichnet durch** zu Beginn Bereitstellen der kapazitiven Elemente, die bei einer ersten Temperatur gesintert werden, gefolgt vom Aufbringen der induktiven Elemente, wonach ein Sintern bei einer zweiten Temperatur durchgeführt wird, die ausreichend niedriger als die erste Sintertemperatur ist, um unerwünschte Reaktionen an Grenzflächen zwischen den ferromagnetischen Zonen und den dielektrischen Zonen zu vermeiden.

2. Verfahren nach Anspruch 1, **dadurch gekennzeichnet, daß** die Temperaturdifferenz zwischen den ersten und zweiten Sintertemperaturen zumindest 50°C und typischerweise 200°C beträgt.

3. Verfahren nach Anspruch 1, **dadurch gekennzeichnet, daß** die kapazitiven Elemente (9, 4, 5) bei einer Temperatur über 1000°C, wie zum Beispiel 1100°C, gesintert werden, während die gesamte Struktur nach dem Aufbringen der induktiven Elemente (6, 7, 8) bei einer Temperatur unter ungefähr 960°C, wie zum Beispiel 910°C, gesintert wird.

4. Verfahren nach einem oder mehreren vorangehenden Anspruch/Ansprüchen, **dadurch gekennzeichnet, daß** die kapazitiven Elemente (9, 4, 5) mittels eines Dielektrikums mit ε_{R} < 250, wie zum Beispiel einem Keramikpulver vom Typ TAM NPO CL750, bereitgestellt werden, das mit einem Bindemittel gemischt wird und in dünnen Schichten gegossen wird, wonach Elektrodenmaterial (4, 5) aufgebracht wird.

## Revendications

1. Procédé de production d'un circuit LC sous la forme d'un composant unique, dans lequel les éléments formant bobine d'inductance et condensateur sont agencés l'un au-dessus de l'autre, et dans lequel les éléments formant bobine d'inductance sont formés par des zones ferromagnétiques constituées de couches (6, 8) de ferrite de forte perméabilité et entre lesquelles des couches d'électrode (7) sont formées, et dans lequel les éléments formant condensateur sont formés par des zones diélectriques réalisées par des couches de diélectrique avec des couches d'électrode des deux côtés, lesdits éléments formant bobine d'inductance et condensateur étant fabriqués au moyen d'une technologie de fabrication de bande ou de couche mince ou d'une association de celles-ci, **caractérisé par** la formation préalable des éléments formant condensateur qui sont frittés à une première température suivie par l'application des éléments formant bobine d'inductance, après quoi, un frittage est réalisé à une seconde température qui est suffisamment inférieure à ladite première température de frittage de manière à éviter des réactions indésirables au niveau des interfaces entre les zones ferromagnétiques et les zones diélectriques.

2. Procédé selon la revendication 1, **caractérisé par** la différence de température entre les première et seconde températures de frittage qui est au moins égale à 50°C et, de manière classique, à 200°C.

3. Procédé selon la revendication 1, **caractérisé en ce que** les éléments formant condensateur (9, 4, 5) sont frittés à une température supérieure à 1000°C, telle que de 1100°C, alors que l'ensemble de la structure, après l'application des éléments formant bobine d'inductance (6, 7, 8), est fritté à une température inférieure à 960°C environ, telle que de 910°C.

4. Procédé selon une ou plusieurs des revendications précédentes, **caractérisé en ce que** les éléments formant condensateur (9, 4, 5) sont formés au moyen d'un diélectrique présentant une permittivité ε_{R} < 250, tel qu'une poudre de céramique du type "TAM NPO CL750", qui est mélangée à un liant et coulé en couches minces, après quoi le matériau d'électrode (4, 5) est appliqué.
